Europäisches Patentamt

**European Patent Office**

Office européen des brevets

(19)

(11) **EP 1 653 528 A2**

(12) **EUROPEAN PATENT APPLICATION**

(43) Date of publication:
**03.05.2006 Bulletin 2006/18**

(51) Int Cl.:
*H01L 51/40* (2006.01)

(21) Application number: **05023648.8**

(22) Date of filing: **28.10.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **01.11.2004 JP 2004317558**

(71) Applicant: **SEIKO EPSON CORPORATION**
**Shinjuku-ku,**
**Tokyo 163-0811 (JP)**

(72) Inventors:
• **Sakai, Shinri**
  **Suwa-shi,**
  **Nagano-ken 392-8502 (JP)**
• **Hirai, Toshimitsu**
  **Suwa-shi,**
  **Nagano-ken 392-8502 (JP)**

(74) Representative: **HOFFMANN EITLE**
**Patent- und Rechtsanwälte**
**Arabellastrasse 4**
**81925 München (DE)**

(54) **Substrate provided with a thin film pattern for an electro-optic device**

(57)    A thin film pattern substrate, including an area provided to the substrate to form a recess and including a wider section and a linear section connected to the wider section, wherein the wider section having a width greater than the width of the linear section, and a thin film pattern provided on the area, wherein a mean diameter of the wider section is set to be no greater than double the width of the linear section.

FIG. 6A

P: SUBSTRATE

EP 1 653 528 A2

FIG. 6B

A

B    A₂    A₁

d    L    b

B

P: SUBSTRATE

FIG. 6C

R₂    L₂

FIG. 6D

L₁    R₁

FIG. 6E

θ    h    R    w

**Description**

BACKGROUND OF THE INVENTION

1. Technical Field

The present invention relates to a substrate provided with a thin film pattern of a predetermined shape such as wiring or an element, a method of manufacturing a device, an electro-optic device, and an electronic instrument.

2. Related Art

As a method of forming a thin film pattern such as wiring used for an electronic circuit or an integrated circuit, the photolithography method, for example, is used. The photolithography method requires a large-scale facility such as a vacuum device and complicated processes, and has availability of materials as low as a few percent, which causes almost all materials be wasted, and accordingly, results in a high manufacturing cost.

As a measure thereto, for example, as shown in JP-A-59-75205, a method of forming a thin film pattern on a substrate using a so-called inkjet process, the droplet ejection process for ejecting a liquid material from a liquid ejection head as a droplet is proposed. According to this method, the thin film pattern is formed by ejecting the liquid material (a functional fluid) for the thin film pattern to a recess section (a fluid receiving section) defined by a lyophobic bank (a diffusion preventing pattern) provided to the substrate, and then drying it by a thermal treatment or laser irradiation. According to this method, the photolithography process can be omitted, thus providing an advantage of dramatically simplifying the process while reducing consumption of the materials.

However, in recent years, a circuit for composing a device has become more and more high-density, and regarding the wiring, for example, a further fine pitch or a further fine line is required. In the thin film forming method using the droplet ejection process described above, the functional fluid landed on a fluid injecting section is lead to a fluid flowing section having a narrow line width to wet it, thus a wiring pattern having a narrower width than the diameter of the landed droplet. In this case, if the amount of the functional fluid (maximum injection amount) that can be injected to the fluid injecting section is large, the amount of the functional fluid flowing into the fluid flowing section can be made large, thus the wiring pattern with a necessary thickness can be formed with a few number (e.g., once) of times of injection (ejection). However, if the maximum injection amount is small, a number of injection of functional fluid are necessary to be executed on the same fluid injecting section with a predetermined time interval to repeatedly execute a number of injection and spreading for wetting. And, the larger the number of repetition becomes, the more often the reduction of the manufacturing efficiency of the substrate to which the thin film pattern such as wiring is provided is caused. And, in order for forming a finer wiring pattern, it is required that the droplet is spread evenly to form the film with an evener thickness. However, the film may be formed with uneven thickness because the droplet flows unevenly when the droplet is landed and then spread on the substrate, or because the evaporation speed of the functional fluid is uneven depending on the landing positions.

In particular, if the film thickness is uneven as described above, unevenness is provided to the formed film, which makes it difficult to stably form a fine thin film pattern. And, the unevenness in the formed film makes it difficult to form the fine thin film pattern while ensuring stability of the quality such as breaking or a short circuit in a devices having a multi-layered structure obtained by further stacking a film thereon.

SUMMARY

An advantage of the invention is to provide a thin film pattern forming substrate capable of precisely and stably forming a thin film pattern having a fine lines and a fine pitch, a method of manufacturing a device, an electro-optic device, and an electronic instrument.

A thin film pattern substrate according to an aspect of the invention includes an area provided to the substrate to form a recess and including a wider section and a linear section connected to the wider section, wherein the wider section having a width greater than the width of the linear section, and a thin film pattern provided on the area, wherein a mean diameter of the wider section is set to be no greater than double the width of the linear section.

According to this aspect of the invention, the functional fluid injected to the wider section flows into the linear section, and the pressure by the surface tension of the functional fluid injected to the wider section and the pressure by the surface tension of the functional fluid flowing into the linear section are balanced with each other. Since the width of the wider section is no greater than double the width of the linear section, the contact angle in the wider section becomes larger than the contact angle of the linear section, thus the maximum fluid accumulating amount of the wider section increases. Further more, since the height of the fluid in the wider section is no greater than double the height of the fluid in the linear section after the functional fluid is injected, therefore the difference in the film thickness after dried to form the thin film can be within the allowable range, thus the thin film pattern without substantial unevenness can be formed to assure evenness of the film thickness. Therefore, the thin film pattern, which hardly causes troubles like breaking lines, can be formed, thus providing the devices with stable quality.

In the thin film pattern substrate according to an aspect of the invention, the wider section has a substantially isotropic shape having substantially the same diameters in different directions, and a mean diameter of the wider section is preferably set to be no greater than double the width of the linear section.

According to this aspect of the invention, the pressure by the surface tension of the functional fluid injected to the wider section and the pressure by the surface tension of the functional fluid flowing into the linear section are substantially balanced with each other in a steady state. Since the width of the wider section is no greater than double the width of the linear section, the contact angle in the wider section becomes larger than the contact angle of the linear section, thus the maximum fluid accumulating amount of the wider section increases. Further more, since the height of the fluid in the wider section is no greater than double the height of the fluid in the linear section after the functional fluid is injected, therefore the difference in the film thickness after dried to form the thin film can be within the allowable range, thus the thin film pattern without substantial unevenness can be formed.

In the thin film pattern substrate according to an aspect of the invention, the wider section has an anisotropic shape having different diameters in different directions, and a mean diameter of the wider section is set to be no greater than double the width of the linear section.

According to this aspect of the invention, the pressure by the surface tension of the functional fluid injected to the wider section and the pressure by the surface tension of the functional fluid flowing into the linear section are substantially balanced with each other in a steady state even if the wider section is an anisotropic shape. Since the width of the wider section is no greater than double the width of the linear section, the contact angle in the wider section becomes larger than the contact angle of the linear section, thus the maximum fluid accumulating amount of the wider section increases. Further more, since the height of the fluid in the wider section is no greater than double the height of the fluid in the linear section after the functional fluid is injected, therefore the difference in the film thickness after dried to form the thin film can be within the allowable range, thus the thin film pattern without substantial unevenness can be formed.

In a thin film pattern substrate according to an aspect of the invention, the substantially isotropic shape of the wider section is a substantially circular shape.

According to this aspect of the invention, the pressure by the surface tension of the functional fluid injected to the wider section and the pressure by the surface tension of the functional fluid flowing into the linear section are substantially balanced with each other in a steady state even if the wider section is a substantially circular shape. Since the width of the wider section is no greater than double the width of the linear section, the contact angle in the wider section becomes larger than the contact angle of the linear section, thus the maximum fluid accumulating amount of the wider section increases. Further more, since the height of the fluid in the wider section is no greater than double the height of the fluid in the linear section after the functional fluid is injected, therefore the difference in the film thickness after dried to form the thin film can be within the allowable range, thus the thin film pattern without substantial unevenness can be formed. Moreover, since the diameter of the droplet of the functional fluid can be set to the maximum diameter, the amount of ejection can be increased, thus enhancing the productivity.

In a thin film pattern substrate according to an aspect of the invention, the anisotropic shape of the wider section is an elliptic shape, and a harmonic average of a minor axis and a major axis of the wider section is set to be no greater than double the width of the linear section.

According to this aspect of the invention, the pressure by the surface tension of the functional fluid injected to the wider section and the pressure by the surface tension of the functional fluid flowing into the linear section are substantially balanced with each other in a steady state even if the wider section is an elliptic shape. Since the width of the wider section is no greater than double the width of the linear section, the contact angle in the wider section becomes larger than the contact angle of the linear section, thus the maximum fluid accumulating amount of the wider section increases. Further more, since the height of the fluid in the wider section is no greater than double the height of the fluid in the linear section after the functional fluid is injected, therefore the difference in the film thickness after dried to form the thin film can be within the allowable range, thus the thin film pattern without substantial unevenness can be formed. Further more, if the landing position of the functional fluid is shifted in some degree, the functional fluid can land efficiently because the wider section has an elliptic shape.

In a thin film pattern substrate according to an aspect of the invention, the wider section is a fluid injecting section to which a functional fluid is injected, the functional fluid being dried to form the thin film pattern, and the linear section is a fluid flowing section having a linear shape and connected to the fluid injecting section so that the functional fluid injected to the fluid injecting section can flow into the fluid flowing section.

According to this aspect of the invention, the pressure by the surface tension of the functional fluid injected to the wider section and the pressure by the surface tension of the functional fluid flowing into the linear section are substantially balanced with each other in a steady state. Since the width of the wider section is no greater than double the width of the linear section, the contact angle in the wider section becomes larger than the contact angle of the linear section, thus the maximum fluid accumulating amount of the wider section increases. Further more, since the height of the fluid in the wider section is no greater than double the height of the fluid in the linear section after the functional fluid is injected, therefore the difference in the film thickness after dried to form the thin film can be within the allowable range, thus the thin film pattern without substantial unevenness can be formed. Further, since the fluid flowing section having a linear shape is connected thereto, the functional fluid injected to the fluid injecting section can easily flow to the fluid flowing section.

The thin film pattern substrate according to another aspect of the invention includes a bank section, and the area provided to form the recess is formed inside the bank section.

According to this aspect of the invention, since the area with the recess is formed inside the bank section, the functional fluid can more easily flow.

In the thin film pattern substrate according to another aspect of the invention, the area with the recess formed inside the bank is preferably a lyophilic section.

According to this aspect of the invention, since the functional fluid injected to the wider section flows in the lyophilic section surrounded by the bank section, the functional fluid more easily flows into the linear section. Therefore, a uniform thin film pattern without substantial unevenness can be formed.

In the thin film pattern substrate according to another aspect of the invention, the functional fluid is preferably injected to the wider section using an inkjet process.

According to this aspect of the invention, since the diameter of the droplet while flying can precisely be controlled, and a finer and more even thin film pattern can be formed by reducing the amount of the ejected functional fluid.

In the thin film pattern substrate according to another aspect of the invention, the area with the recess formed inside the bank is preferably a conductive pattern.

According to this aspect of the invention, fine thin film pattern having conductivity can be formed.

A method of manufacturing a device according to an aspect of the invention is a method of manufacturing a device on a surface of the substrate, including the step of forming a wider section on the substrate, the step of forming a linear section on the substrate so that the linear section is connected to the wider section to allow a functional fluid to flow, the step of injecting the functional fluid to the wider section, the step of allowing the functional fluid to flow from the wider section into the linear section, and the step of drying the functional fluid flowing into the linear section to form a thin film pattern, wherein a mean diameter of the wider section is set to be no greater than double the width of the linear section.

According to this aspect of the invention, the pressure by the surface tension of the functional fluid injected to the wider section and the pressure by the surface tension of the functional fluid flowing into the linear section are substantially balanced with each other in a steady state. Since the width of the wider section is no greater than double the width of the linear section, the contact angle in the wider section becomes larger than the contact angle of the linear section, thus the maximum fluid accumulating amount of the wider section increases. Further more, since the height of the fluid in the wider section is no greater than double the height of the fluid in the linear section after the functional fluid is injected, therefore the difference in the film thickness after dried to form the thin film can be within the allowable range, thus the thin film pattern without substantial unevenness can be formed. And further, since it is arranged that the fluid flows from the wider section to the linear section, a thin film pattern having an even thickness without substantial unevenness can be formed. Therefore, a device having a finer thin film pattern which hardly causes any quality problems such as breaking or short circuit can be obtained.

An electro-optic device according to an aspect of the invention includes a device having the thin film pattern substrate described above.

According to this aspect of the invention, since the device with finer pattern is included, the electro-optic device with higher precision and suitable for down-sizing can be provided.

An electronic instrument according to still another aspect of the invention includes the electro-optic device according to the above aspect of the invention.

According to this aspect of the invention, since the electro-optic device with higher precision and suitable for down-sizing is included, the electronic instrument with higher-precision can be provided.

BRIEF DESCRIPTION OF THE DRAWINGS

The invention will now be described with reference to the accompanying drawings, wherein like numbers refer to like elements.

Fig. 1 is a schematic perspective view of a droplet ejection device.

Fig. 2 is a schematic view for explaining a principle of ejecting a liquid material using a piezoelectric method.

Fig. 3 is a flowchart showing a method of forming a thin film pattern.

Figs. 4A through 4C are schematic views for showing processes of forming a thin film pattern.

Figs. 5A through 5C are schematic views for showing processes of forming a thin film pattern.

Figs. 6A through 6E are schematic views for showing a thin film pattern forming method as a first embodiment of the invention, wherein Fig. 6A is a plan view, Fig. 6B is a view with a functional fluid dropped thereon, Figs. 6C and 6D are perspective views of the droplet of the functional fluid, Fig. 6E is a diagram for showing the contact angle.

Figs. 7A and 7B are schematic views for showing a thin film pattern forming method as a second embodiment of the invention, wherein Fig. 7A is a plan view and Fig. 7B is a view with a functional fluid dropped thereon.

Figs. 8A and 8B are schematic views for showing a thin film pattern forming method as a third embodiment of the invention, wherein Fig. 8A is a plan view and Fig. 8B is a view with a functional fluid dropped thereon.

Fig. 9 is a schematic diagram for showing an example of a plasma processing device used in a residual dross processing step.

Fig. 10 is a plan view of a liquid crystal display device seen from an opposed substrate.

Fig. 11 is a cross-sectional view along the H-H' line of Fig. 10.

Fig. 12 is a circuit diagram of an equivalent circuit of the liquid crystal display device.

Fig. 13 is a partial enlarged cross-sectional view of the liquid crystal display device.

Fig. 14 is an exploded perspective view of a noncontact card medium.

Figs. 15A through 15C are schematic views showing specific examples of electronic instruments.

DESCRIPTION OF THE EMBODIMENTS

Hereinafter, some embodiments of a method of forming a thin film pattern and a method of manufacturing a device according to the invention will be cited and explained in detail with reference to the accompanying drawings. In the present embodiment, the description will be made using the case as an example, in which a wiring pattern formed of a conductive film is provided on a substrate by ejecting ink (functional fluid, the wiring pattern (thin film pattern) forming ink) containing conductive fine particles as droplets from an ejection nozzle of a droplet ejection head using a droplet ejection process.

First Embodiment

Firstly, the ink (functional fluid) to be used will be explained. The wiring pattern forming ink, which is a liquid material, is composed of a dispersion liquid made by dispersing the conductive fine particles into a dispersion medium. In the present embodiment, metal fine particles including at least one of, for example, gold, silver, copper, aluminum, palladium, and nickel, or oxides thereof, fine particles of electrically conductive polymers or superconductive materials can be used as the electrically conductive fine particles. In order to enhance dispersibility, these conductive fine particles can be used with organic matters coated on the surfaces. The particle sizes of the conductive fine particles are preferably no smaller than 1.0nm and no greater than 1.0$\mu$m. If the particle sizes are greater than 1.0$\mu$m, clogging may occur in the ejection nozzles of the droplet ejection head 1 described below. Further, if it is smaller than 1nm, the volume ratio of the coating agent with respect to the conductive fine particles becomes larger, the ratio of the organic matters in the resulting film becomes too large.

The dispersion medium is not limited providing it can disperse the electrically conductive fine particles described above and does not cause any agglutinations. For example, other than water, alcohol such as methanol, ethanol, propanol, or butanol, carbon hydride compounds such as n-heptane, n-octane, decane, dodecane, tetradecane, toluene, xylene, cymene, durene, indene, dipentene, tetrahydronaphthalene, decahydronaphthalene, or cyclohexylbenzene, etherates such as ethyleneglycoldimethylether, ethyleneglycoldiethylether, ethyleneglycolmethylethylether, diethyleneglycoldimethylether, diethyleneglycoldiethylether, diethyleneglycolmethylethylether, 1, 2-dimethoxyethane, bis(2-methoxyethyl)ether, or p-dioxane, and further polar compounds such as propylene carbonate, $\tilde{a}$-butyrolactone, N-nethyl-2-pyrrolidone, dimethylformamide, dimethylsulfoxide, or cyclohexanone can be exemplified. In the above compounds, in view of dispersibility of the fine particles and stability of the dispersion liquid, further facility of applying to the droplet ejection method, water, alcohol, carbon hydride compounds, and etherates are preferable, and more preferably, water and carbon hydride compounds can be cited.

The surface tension of the dispersion liquid of the conductive fine particles is preferably in a range of no less than 0.02N/m and no greater than 0.07N/m. When the ink is ejected using the droplet ejection process, the surface tension of less than 0.02N/m easily causes the curved flight because the wettability of the nozzle surface to the ink is increased, on the one hand, and the surface tension of greater than 0.07N/m makes it difficult to control the ejection amount or the ejection timing because the shapes of the meniscuses in the nozzle tips are not stabilized, on the other hand. In order for adjusting the surface tension, a minute amount of a surface tension adjustment agent such as a fluorinated agent, a silicone agent, or a nonionic agent is preferably added to the dispersion liquid as long as the contact angle with the substrate is not substantially decreased. The nonionic surface tension adjustment agent enhances wettability of the substrate to the ink, improves the leveling property of the film, and works for preventing microscopic unevenness of the film. The surface tension adjustment agent can include an organic compound such as alcohol, ether, ester, or ketone, if necessary.

The viscosity of the dispersion liquid is preferably in a range of no less than 1mPa·s and no greater than 50mPa·s. When the ink is ejected as the droplets using the droplet ejection process, the viscosity of less than 1mPa·s easily causes contamination in the periphery of the nozzles with the outflow of the ink, and the viscosity of greater than 50mPa·s increases the frequency of the clogging in the nozzle holes, thus making the smooth ejection of the droplets difficult.

As the substrate to which the wiring pattern is provided, various kinds of materials such as glass, quartz glass, a Si wafer, a plastic film, a metal plate, or ceramics can be used. Further, the surface of each of the substrates formed of the various materials can be provided with a semiconductor film, a metal film, a dielectric film, an organic film, or an insulating film as a foundation layer.

Note that, as an ejection technology used for the droplet ejection method, the charge control method, the pressure vibration method, electromechanical conversion method, electrothermal conversion method, electrostatic absorption method, and so on can be cited. In the charge control method, the material is charged by a charge electrode and ejected from an ejection nozzle while its flight orientation is controlled by a deflection electrode. Further, in the pressure vibration method, the material is ejected from the tip of the nozzle by being applied with very high pressure of about 30 kg/cm$^2$, and when no control voltage is applied, the material is forwarded straight to be ejected from the ejection nozzle, and when the control voltage is applied, an electrostatic repelling force is generated in the material to cause the material to fly in various directions and not to be ejected from the ejection nozzle. Further, in the electromechanical conversion method, the characteristics of the piezoelectric element that distorts in response to a pulsed electric signal are utilized, and when the piezoelectric element distorts, pressure is applied to a chamber containing the material via an elastic member to push the material out of the chamber to eject it from the ejection nozzle.

Further, in the electrothermal conversion method, the material is rapidly vaporized to generate a bubble by a heater provided in a chamber containing the material, and the material in the chamber is ejected by a pressure caused by the bubble. In the electrostatic absorption method, minute pressure is applied to a chamber containing the material to form a meniscus at the ejection nozzle, and then electrostatic absorption force is applied in this condition to take the material out of the nozzle. Other than the above methods, a method utilizing viscosity alteration of fluid by electric field or a method for flying the material by discharge sparks can also be adopted. The droplet ejection method has advantages that there is little waste in using the material and that a desired amount of material can precisely be disposed on a desired position. Note that the weight of one droplet of the material ejected by the droplet ejection method is, for example, 1 through 300 nanograms.

Device manufacturing equipment used for manufacturing the device according to the embodiment of the invention will hereinafter be explained. As the device manufacturing equipment, a droplet ejection device (an inkjet device) IJ for manufacturing the device by ejecting (dropping) droplets from the droplet ejection head 1 to the substrate is used.

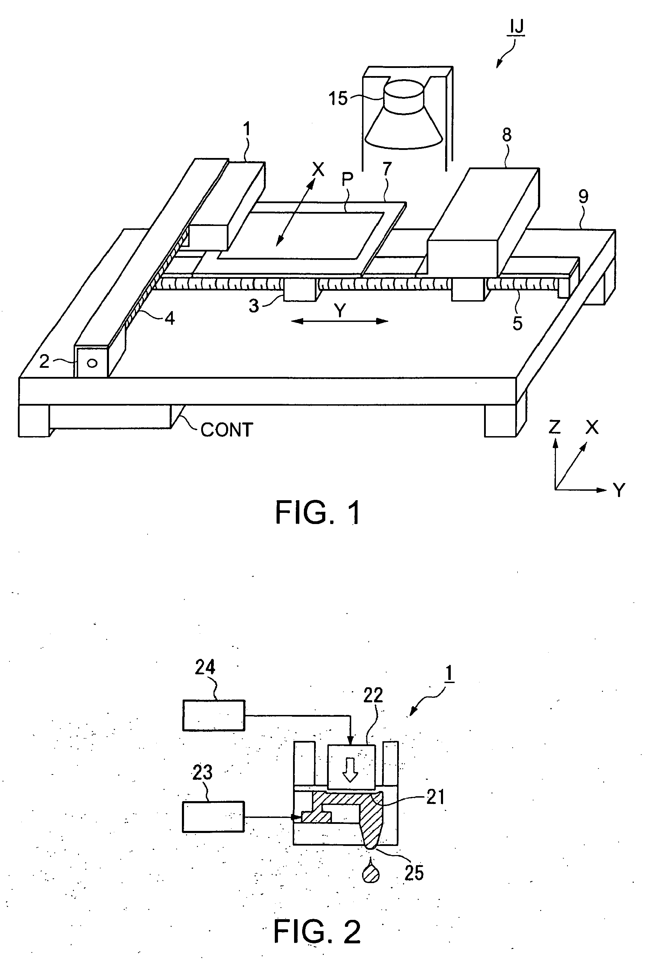

Fig 1 is a perspective view schematically showing the configuration of the droplet ejection device IJ.

In Fig. 1, the droplet ejection device IJ is equipped with the droplet ejection head 1, an X axis direction drive shaft 4, a Y axis direction guide shaft 5, a control device CONT, a stage 7, a cleaning mechanism 8, a base member 9, and a heater 15.

The stage 7 is for supporting the substrate P to which the ink is disposed by the droplet ejection device IJ, and is equipped with a fixing mechanism not shown for fixing the substrate P to a reference position.

The droplet ejection head 1 is a multi-nozzle type droplet ejection head equipped with a number of ejection nozzles, and the longitudinal direction thereof is conformed to the X axis direction. The number of ejection nozzles are provided to the lower surface of the droplet ejection head 1 so as to be aligned in the X axis direction with a constant interval. The ink containing the conductive fine particles described above is ejected from the ejection nozzles of the droplet ejection head 1 to the substrate P supported by the stage 7.

An X axis direction drive motor 2 is connected to the X axis direction drive shaft 4. The X axis direction drive motor 2 is, for example, a stepping motor, and rotates the X axis direction drive shaft 4 when a drive signal of the X axis direction is supplied from the control device CONT. In response to the rotation of the X axis direction drive shaft 4, the droplet ejection head 1 moves in the X axis direction.

The Y axis direction guide shaft 5 is fixed to the base member 9 so as not to move therefrom. The stage 7 is equipped with a Y axis direction drive motor 3. The Y axis direction drive motor 3 is, for example, a stepping motor, and moves the stage 7 in the Y axis direction when a drive signal of the Y axis direction is supplied from the control device CONT.

The control device CONT supplies the droplet ejection head 1 with a voltage for controlling the droplet ejection. Further, the control device CONT supplies the X axis direction drive motor 2 with a drive pulse signal for controlling movement of the droplet ejection head 1 in the X axis direction, and at the same time, it supplies the Y axis direction drive motor 3 with a drive pulse signal for controlling the movement of the stage 7 in the Y axis direction.

The cleaning mechanism 8 is for cleaning the droplet ejection head 1, and is equipped with a Y axis direction drive motor not shown in the drawings. By driving the Y axis direction driving motor, the cleaning mechanism 8 moves along the Y axis direction guide shaft 5. The movement of the cleaning mechanism 8 is also controlled by the control device CONT.

A heater 15 here is means for thermal-treating the substrate P by a lamp anneal process, and performs evaporation of the solvent included in the ink coated on the substrate P and dries the substrate. The control device CONT also controls powering on or off of the heater 15.

The droplet ejection device IJ ejects the droplets to the substrate P while scanning the droplet ejection head 1 relatively to the stage 7 supporting the substrate P. Here, in the description below, it is assumed that the Y axis direction is the scanning direction and the X axis direction perpendicular to the Y axis direction is the non-scanning direction. Therefore, the ejection nozzles of the droplet ejection head 1 are provided so as to be aligned in the X axis direction, the non-scanning direction, with a constant interval. Note that, although the droplet ejection head 1 is aligned perpendicular to the moving direction of the substrate P in Fig. 1, the angle of the droplet ejection head 1 can be adjusted so that it traverses the moving direction of the substrate P. By thus arranged, the nozzle pitch can be adjusted by altering the angle of the droplet ejection head 1. Further, the distance between the substrate P and the surface provided with the nozzles can be arranged to be adjusted in accordance with the necessity.

Fig. 2 is a schematic view for explaining the principle of ejecting the liquid material according to the piezoelectric method.

In Fig. 2, piezoelectric elements 22 are disposed adjacent to a fluid chamber 21 for containing the liquid material (the wiring pattern forming ink, the functional fluid). The liquid material is supplied to the fluid chamber 21 via a liquid material supply system 23 including a material tank for containing the liquid material. The piezoelectric element 22 is connected to a drive circuit 24, and by applying voltage to the piezoelectric element 22 via the drive circuit 24 to distort the piezoelectric element 22, the fluid chamber is also distorted to eject the liquid material from the ejection nozzle 25. In this case, an amount of distortion of the piezoelectric element 22 can be controlled by altering the value of the applied voltage. Further, the velocity of distortion of the piezoelectric element 22 can be controlled by altering the frequency of the applied voltage. Since no substantial heat is applied to the material in ejecting droplet using the piezoelectric method, an advantage that the composition of the material is hardly affected is obtained.

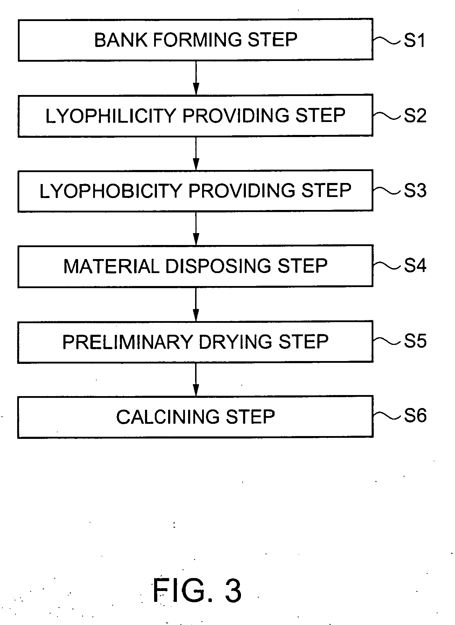

An embodiment of a method of forming a wiring pattern according to the invention will hereinafter be described with reference to Figs. 3, 4A through 4C, 5A through 5C, and 6A through 6E.

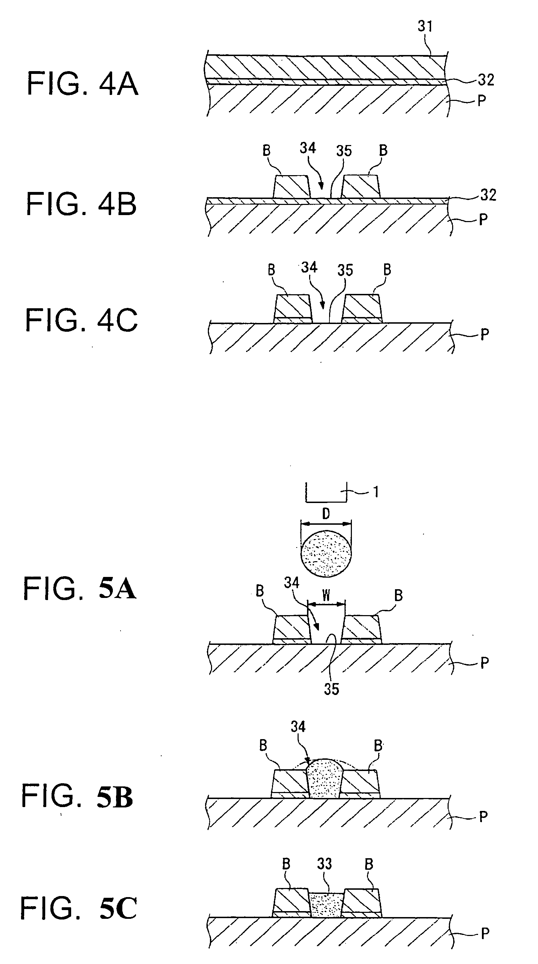

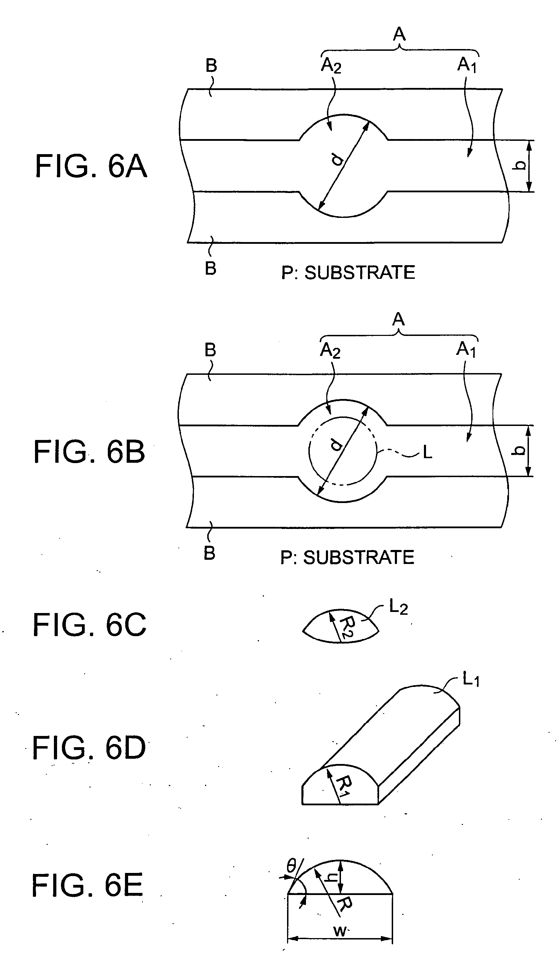

Fig. 3 is a flowchart showing an example of the wiring pattern forming method according to the present embodiment, Figs. 4A through 4C, and 5A through 5C are schematic views showing the forming processes, and Figs. 6A through 6E are conceptual schematic diagrams of the thin film pattern forming method.

As shown in Fig. 3, the wiring pattern forming method according to the present embodiment is for forming a wiring pattern of a conductive film on the substrate by disposing the wiring pattern forming ink on the substrate, and includes a bank forming step S1 for providing a bank corresponding to the wiring pattern on the substrate in an extended condition, a lyophilicity providing step S2 for providing the substrate with lyophilicity, a lyophobicity providing step S3 for providing the bank with lyophobicity, a material disposing step S4 for disposing ink on an area surrounded by the bank provided with lyophobicity, a preliminary drying step S5 for removing at least a part of liquid component of the ink, and a calcining step S6. Hereinafter, each of the steps will be explained in detail. In the present embodiment, a glass substrate is used as the substrate P.

Bank Forming Step

Firstly, prior to coating of an organic material, the HMDS treatment is executed on the substrate P as a surface reformulation process. The HDMS treatment is executed by coating vapor form of hexamethyldisilazane ($(CH_3)_3SiNHSi(CH_3)_3$). By this treatment, as shown in Fig. 4A, the HMDS layer 32 as an adhesion layer for enhancing adhesiveness of the substrate P with the bank is formed on the substrate 32.

The bank is a member functioning as a separating member, and can be formed using a desired process such as a photolithography process or a printing process. If, for example, a photolithography process is used, an organic photosensitive material is coated on the HMDS layer 32 of the substrate using a predetermined process such as a spin costing process, a spray coating process, a roll coating process, a dye coating process, or a dip coating process so that the height thereof matches the height of the bank, and then a resist layer is coated thereon. And, the resist provided with a mask corresponding to the shape of the bank (the wiring pattern) is exposed and then developed to leave the resist corresponding to the shape of the bank. Finally, the bank material in other areas than the mask area is removed by etching. Further, the bank (the extended section) can also be formed as a multi-layered structure composed of a lower layer made of an inorganic matter and an upper layer made of an organic matter. Thus, as shown in Fig. 4B, the bank B is provided in an extended condition so as to surround the periphery of the area on which the wiring pattern is to be formed. Note that, as a shape of the bank B thus formed, a tapered shape having a narrower width in the upper section and a wider width in the bottom section is preferable because the droplet of the ink is easy to flow into a groove section defined by the bank as described below.

As the organic material for forming the bank, a material presenting lyophobicity with the ink can be used, or as described below, an insulating organic material, which can be provided with lyophobicity (can be fluorinated) by a plasma process, has good adhesiveness with the base substrate, and can be easily patterned by a photolithography process, can also be used. For example, a polymer material such as acrylic resin, polyimide resin, olefin resin, phenol resin, or melamine resin can be used. Alternatively, a material having an inorganic framework (siloxane bond) in the principal chain with an organic group attached thereto can also be used.

After forming the bank B on the substrate P, a hydrofluoric acid treatment is executed. The hydrofluoric acid treatment is a treatment for removing the HMDS layer 32 surrounded by the bank B by etching with, for example, 2.5% hydrofluoric acid. In the hydrofluoric acid treatment, the bank B functions as a mask, and, as shown in Fig. 4C, the HMDS layer 32, which is an organic matter and is positioned at the bottom 35 of the recess 34 formed in the area surrounded by the bank B, is removed to expose the substrate P.

Lyophilicity Providing Step

Subsequently, the lyophilicity providing process for providing lyophilicity to the bottom 35 (the exposed section of the substrate P) surrounded by the bank B is executed. As the lyophilicity providing process, an ultraviolet (UV) irradiation process for exposing to ultraviolet radiation, an $O_2$ plasma process using oxygen as a process gas in the atmospheric conditions, or the like can selectively be used. In the present embodiment, the $O_2$ plasma process is executed.

In the $O_2$ plasma process, the substrate P is irradiated with oxygen in a plasma state discharged from a plasma discharge electrode. In an example of conditions of the $O_2$ plasma process, for example, the plasma power is in a range of 50 through 1000W, the flow rate of the oxygen gas is in a range of 50 through 100mL/min, the relative moving velocity of the substrate P to the plasma discharge electrode is in a range of 0.5 through 10mm/sec, and the temperature of the substrate is in a range of 70 through 90˚C.

And, if the substrate P is formed of a glass substrate whose surface is lyophilic with respect to the wiring pattern forming ink, the lyophilicity of the surface (the bottom 35) of the substrate P exposed in the area surrounded by the bank B can further be enhanced by executing the $O_2$ plasma process or the ultraviolet radiation process as in the present embodiment. Here, the $O_2$ plasma process or the ultraviolet radiation process is preferably executed so that the contact angle of the bottom section 35 surrounded by the bank with respect to the ink becomes no greater than 15 degrees.

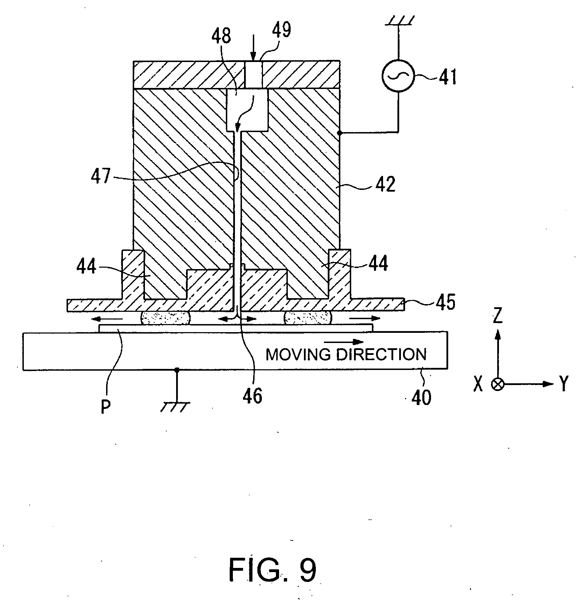

Fig. 9 is a schematic view showing the configuration of an example of the plasma processing device used for executing the $O_2$ plasma process. The plasma process device shown in Fig. 9 includes an electrode 42 connected to an AC power supply 41 and a sample table 40, which is a grounding electrode. The sample table 40 is arranged to be able to move in the Y axis direction while supporting the substrate P. On the lower surface of the electrode 42, there are provided two parallel discharge generating sections 44 extended in the X axis direction perpendicular to the moving direction in protruded conditions, and a dielectric member 45 is also provided so as to surround the discharge generating sections 44. The dielectric member 45 is for preventing abnormal discharge in the discharge generating sections 44. And, the lower surface of the electrode 42 including the dielectric member 45 is substantially flat, and it is arranged that small gaps (the discharge gaps) are provided between the discharge generating sections 44 including the dielectric member 45 and the substrate P. Further, at the center of the electrode 42, there is provided a gas ejection port 46, which forms a part of a process gas supplying section formed as a shape elongated in the X axis direction. The gas ejection port 46 is connected to a gas introduction port 49 via a gas channel 47 and an intermediate chamber 48 inside the electrode.

A predetermined gas including the process gas ejected from the gas ejection port 46 through the gas channel 47 flows in the gap while being separated into two directions, the forward direction and the backward direction of the moving direction (the Y axis direction), and is exhausted to the outside from the front end and back end of the dielectric member 45. At the same time, a predetermined voltage is applied to the electrode 42 from the power supply 41, and gaseous discharge occurs between the discharge generating sections 44 and the sample table 40. And, the plasma generated by the gaseous discharge generates active species of the predetermined gas in the excited state to continuously process the whole surface of the substrate P passing through the discharge area.

In the present embodiment, the predetermined gas is a mixture of oxygen ($O_2$) as a process gas and a noble gas such as helium (He) or argon (Ar) or an inactive gas such as nitrogen ($N_2$) for easily beginning and stably maintaining discharge under pressure nearly equal to the atmospheric pressure. In particular, by using oxygen as the process gas, residual dross of organic matters (the resist or the HMDS) generated in the bottom 35 of the bank B in forming the bank can be removed. In other words, there are some cases in which the HMDS (an organic matter) of the bottom section 35 surrounded by the bank B is not completely removed by the hydrofluoric acid treatment described above. Or, in some cases, the resist (an organic matter) used for forming the bank remains on the bottom 35 of the bank B. Therefore, by executing the $O_2$ plasma process, the residual dross on the bottom 35 surrounded by the bank B can be removed.

Note that, although the description reads here that the HMDS layer 32 is removed by executing the hydrofluoric acid treatment, the hydrofluoric acid treatment can be omitted because the HMDS layer 32 at the bottom section 35 surrounded by the bank is fully removed by the $O_2$ plasma process or the ultraviolet radiation process. Further, although the description reads here that either one of the $O_2$ plasma process and the ultraviolet radiation process is executed as the lyophilicity providing process, both of the $O_2$ plasma process and the ultraviolet radiation process can obviously be executed in combination.

Lyophobicity Providing Step

Subsequently, a lyophobicity providing process is executed to the bank B to provide lyophobicity to the surface thereof. As the lyophobicity providing process, a plasma process method ($CF_4$ plasma process method) using tetrafluoromethane as the process gas is adopted. In an example of conditions of the $CF_4$ plasma process, the plasma power is in a range of 50 through 1000W, the flow rate of the tetrafluoromethane gas is in a range of 50 through 100mL/min, the relative movement velocity of the base body to the plasma discharge electrode is in a range of 0.5 through 20mm/sec, and the temperature of the base body is in a range of 70 through 90˚C. Note that the process gas is not limited to tetrafluoromethane, but other fluorocarbon gases or a gas such as $SF_6$, $SF_5$, or $CF_3$ can also be used as the process gas. In the $CF_4$ plasma process, the plasma processing device explained above with reference to Fig. 9 can be used.

By executing such a lyophobicity providing process, the bank B is provided with fluoric groups introduced in the resin forming the bank, thus high lyophobicity is provided to the bank B. Note that, although the $O_2$ plasma process as the lyophilicity providing process described above can be executed prior to formation of the bank B, the $O_2$ plasma process is preferably executed after the bank B has been formed because a polymer material such as acrylic resin or polyimide resin has the nature of being more easily fluorinated (provided with lyophobicity) with a pretreatment with $O_2$ plasma.

Note also that, although the lyophobicity providing process for the bank B slightly affects the lyophilicity of the exposed section of the substrate P surrounded by the bank B, which has previously been treated to have lyophilicity, particularly in case the substrate P is made of glass or the like, the lyophilicity (wettability, in other words) of the substrate P is practically maintained because no adoption of fluoric groups occurs during the lyophobicity providing process.

It is regarded that the surface reformulation treatment for providing the bank B with higher lyophobicity than the lyophobicity of the bottom section 35 surrounded by the bank by the lyophilicity providing process and the lyophobicity providing process described above. Note that, although the $O_2$ plasma process is executed here as the lyophilicity providing process, since the introduction of fluoric groups caused by the lyophobicity providing process does not occur with the substrate made of glass or the like, as described above, the bank B can be provided with higher lyophobicity than the bottom section 35 surrounded by the bank by executing only the $CF_4$ plasma process without executing the $O_2$ plasma process.

Material Disposing Step

Subsequently, the droplets of the wiring pattern forming ink are disposed on the area of the substrate P surrounded by the bank B using the droplet ejection process by the droplet ejection device IJ. Note here that organo-silver compounds are used as the conductive material, and the ink containing the organo-silver compounds and diethyleneglycoldiethylether as a solvent (a dispersion medium) is ejected. In the material disposing process, as shown in Fig. 5A, the ink containing the pattern forming material is ejected from the droplet ejection head 1 as a droplet. The droplet ejection head 1 ejects the droplet of the ink to the recess section 34 surrounded by the bank B to dispose the ink in the recess section 34. In this step, since the area (namely the recess section 34) for forming the wiring pattern to which the droplet is ejected is surrounded by the bank B, the droplet is prevented from expanding beyond a predetermined area.

In the present embodiment, the width W of the recess section 34 surrounded by the bank B (here, the width of an opening section of the recess section 34) is arranged to be smaller than the diameter D of the droplet of the ink (functional fluid). Note that the ambient atmosphere for ejecting the droplets is preferably set to have temperature of no higher than 60˚C and moisture of no higher than 80%. Thus, more stable droplet ejection can be executed without any clogging in the ejection nozzles of the droplet ejection head 1.

When such a droplet is ejected from the droplet ejection head 1 to dispose in the recess 34, a part of the droplet is positioned on the bank B as illustrated with the chain double-dashed line in Fig. 5B, because the diameter D of the droplet is larger than the width W of the recess section 34. However, since the bank B has a lyophobic surface and a tapered shape, the part of the droplet positioned on the bank B is repelled by the bank B and further flows down into the recess 34 by the capillary phenomenon, thus the whole droplet is positioned inside the recess 34 as illustrated with the solid line in Fig. 5B.

Further, the ink ejected into the recess 34 or flowing down to the recess from the bank B easily spread on to wet the substrate P (the bottom section 35) provided with lyophilicity, thus the ink can cover more evenly the inside of the recess 34.

Preliminary Drying Step

After ejecting the droplets to the substrate P, a drying process is executed for removing the dispersion medium and for keeping the film thickness if necessary. The drying process can be executed by, for example, an ordinary hot plate for heating the substrate P, a process using an electrical heating furnace, or lamp annealing. A light source for the lamp annealing process is not particularly limited, but a infrared lamp, a xenon lamp, a YAG laser, an argon laser, a carbon oxide gas laser, or excimer laser using XeF, XeCl, XeBr, KrF, KrCl, ArF, or ArCl can be used as the light source. The light sources having an output power of no less than 10W and no greater than 5000W can generally be used, but in the present embodiment, those of no less than 100W and no greater than 1000W are sufficient. And, by repeatedly executing the preliminary drying step and the material disposing step described above, as shown in Fig. 5C, the wiring pattern (the thin film pattern) 33 composed of a number of layers of ink droplets stacked each other and having a substantial thickness can be formed.

Calcining Step

If the dried film after the ejection process is composed of the organo-silver compounds, a thermal treatment needs to be executed to remove the organic component and to leave the silver particles in order to obtain conductivity. Therefore, a thermal treatment and/or a light treatment is executed on the substrate executed through the ejection process.

The thermal treatment and/or the light treatment are usually executed in the atmosphere, and can be executed in an inactive ambient gas such as nitrogen, argon, or helium, or a reducing ambient gas such as hydrogen if necessary. The process temperature of the thermal treatment and/or the light treatment is appropriately decided taking the boiling point (the vapor pressure) of the dispersion medium, the nature or pressure of the ambient gas, thermal behavior of the fine particles such as dispersibility or oxidation property, presence or absence or an amount of the coating material, an allowable temperature limit of the base member, and so on into consideration. In the present embodiment, a calcining process in the atmosphere using a clean oven at a temperature in a range of 280 through 300°C for 300minutes is executed on the ink ejected to form the pattern. Note that, for example, the organo-silver compounds need to be baked at 200°C to remove the organic components. Further, in case of using a substrate made of plastic or the like, it is preferably executed at a temperature no lower than the room temperature and no higher than 250°C. By the steps described above, electrical contact between the fine particles is assured in the dried film executed through the ejection process, and the dried film is changed to be the conductive film.

Note that, the banks B existing on the substrate P can be removed by an ashing separation process after the calcining process. As the ashing process, a plasma ashing process or an ozone ashing process or the like can be adopted. In the plasma ashing process, the bank (the resist) is reacted with the plasma gas such as oxygen gas to vaporize the bank, thus the bank is separated and removed. The bank is a solid substance composed of carbon, oxygen, and hydrogen, and reacts with the oxygen plasma to generate $CO_2$, $H_2O$, and $O_2$, and can completely be separated as gases. Meanwhile, the basic principle of the ozone ashing process is the same as the plasma ashing process, and $O_3$ (ozone) is decomposed to be the reactive gas $O^+$ (oxygen radical), and then the bank is reacted with $O^+$. The bank reacting with $O^+$ becomes $CO_2$, $H_2O$, and $O_2$, and is completely separated as gases. By executing the ashing process on the substrate P, the bank is removed from the substrate P. As a process for removing the bank, other than the ashing separation process, a process of resolving the bank with a solvent or a process of physically removing the bank can also be executed.

The thin film pattern forming method as the first embodiment of the invention will be explained here. As shown in Fig. 6A, when forming the bank B on the substrate P, the thin film pattern is formed after providing a linear area A defined by the bank B with a part having a wider width. Further, it is arranged that the shape of a fluid injecting section A2 is a circle, and the shape of a fluid flowing section A1 is a thin groove. Note that it is arranged that the fluid injecting section A2 and the fluid flowing section A1 are disposed in a line, and further, the width d of the fluid injecting section A2 is no greater than double the width b of the fluid flowing section A1. Further, although the fluid injecting section A2 and the fluid flowing section A1 are arranged to be disposed in a straight line, the arrangement is not so limited. They can be disposed in a curved line.

As shown in Fig. 6B, it is arranged that the bank B is formed on the substrate P, and the functional fluid L can be disposed on the linear area A (forming the fluid injecting section A2 and the fluid flowing section A1) defined by the bank B. In particular, it is arranged that, when the functional fluid L is injected to the fluid injecting section A2 from the nozzles of the droplet ejection head 1, the injected functional fluid L flows to the fluid flowing section A1.

Further, according to the present thin film pattern forming method, since the width d of the fluid injecting section A2 of the linear area A partitioned by the bank B is formed to be no larger than double the width b of the fluid flowing section A1, the functional fluid L flows efficiently from the fluid injecting section A2 to the fluid flowing section A1 when the functional fluid is disposed. When the droplets of the functional fluid L repeatedly land on the fluid injecting section A2, the functional fluid L accumulated in the fluid injecting section A2 gradually rises, and then gradually flows from the fluid injecting section A2 to the fluid flowing section A1. The functional fluid L flowing to the fluid flowing section A1 is accumulated in the fluid flowing section A1.

In this state, the functional fluid L is disposed on the linear area A partitioned by the bank B, and by, for example, drying the functional fluid L, the film pattern F having a linear shape is formed on the substrate P. In this case, since the shape of the film pattern F is defined by the bank B, the bank B is appropriately formed to have, for example, narrower width in the adjacent section to the fluid flowing section A1 in order for obtaining the film pattern F having a finer pitch or a finer line width.

Further, when forming the bank B on the substrate P, the fluid injecting section A2 formed to have a wider width d and the fluid flowing section A1 formed to have a narrower width b can be provided to the linear area A partitioned by the bank B. Namely, one or more sections having wider width d than other sections having width b (d>b) can be provided at predetermined positions in the longitudinal direction of the linear area A.

In general, when a liquid is disposed in a linear area, there are some cases in which it is difficult for the liquid to flow from the fluid injecting section A2 to the fluid flowing section A1 or it is difficult for the liquid to spread in the area because of the operation of the surface tension of the liquid. In contrast, according to the thin film pattern forming method of the present embodiment, since the line width of the fluid injecting section A2 and the line width of the fluid flowing section A1 are different from each other, and further, the width of the fluid injecting section A2 is set to be no larger than double the width of the fluid flowing section A1, the movement of the liquid in this section triggers the movement of the functional fluid L to the fluid flowing section A1 or in the fluid flowing section A1, thus enhancing the functional fluid L to flow into the fluid flowing section A1 or to spread in the fluid flowing section A1.

As described above, since the functional fluid L is promoted to flow from the bank B when disposing the functional fluid L, the film pattern F can be formed to be a desired shape. Accordingly, the film pattern F having a fine line shape can precisely and stably be formed.

Here, descriptions will be added regarding that the width of the fluid injecting section A2 is no larger than double the width of the fluid flowing section A1 with reference to Figs. 6C and 6D.

When the functional fluid L is dropped and landed on the fluid injecting section A2, the functional droplet L2 accumulated in the fluid injecting section A2 becomes hemispheric shape by the force to stabilize the surface tension (See Fig. 6C.).

Here, assuming that the diameter of the fluid injecting section A2 is d, the line width of the fluid flowing section A1 is b, the pressure of the functional droplet L2 accumulated in the fluid injecting section A2 is $P_2$, the surface tension is $\sigma$, the liquid surface curvature radius is $R_2$, the relationship between $P_2$, $\sigma$, $R_2$ is given as follows, and the pressure $P_2$ of the functional droplet L2 accumulated in the fluid injecting section A2 is obtained by the following mathematical formula (1).

$$P_2 = \sigma \left( \frac{1}{R_2} + \frac{1}{R_2} \right) = \frac{2\sigma}{R_2} \qquad \cdots \ (1)$$

Subsequently, the functional droplet L2 existing in the fluid injecting section A2 starts flowing to the fluid flowing section A1. In this case, although the functional droplet L2 tries to be stable as described above, since the fluid flowing section A1 has a thin groove shape, the functional droplet L1 starts flowing along the longitudinal direction of the fluid flowing section A1 and forms a hog-backed shape (substantial semi-cylindrical shape) (See Fig. 6D.).

Here, assuming that the pressure of the functional droplet L1 in the fluid flowing section A1 is $P_1$, the surface tension is $\sigma$, the curvature radius in the width direction is $R_1$, and the curvature radius in the longitudinal direction is $R_3$, the curvature radius $R_3$ can be regarded as $\infty$, and the relationship between $P_1$, $\sigma$, $R_1$ is given as follows, and the pressure $P_1$ in the fluid flowing section A1 is obtained by the following mathematical formula (2).

$$P_1 = \sigma \left( \frac{1}{R_1} + \frac{1}{\infty} \right) = \frac{\sigma}{R_1} \qquad \cdots \ (2)$$

Since the pressure $P_1$ in the fluid flowing section A1 and the pressure $P_2$ in the fluid injecting section A2 are balanced with each other in a steady state, $P_1$ equals to $P_2$, and the following mathematical formula (3) is obtained from the formula (1) and the formula (2).

$$2R_1 = R_2 \qquad \cdots \ (3)$$

Here, the contact angles in the fluid injecting section A2 and the fluid flowing section A1 will be explained with reference to Fig. 6E.

As shown in Fig. 6E, assuming that the curvature radius of the droplet L is R, the height of the fluid is h, the width of the base section is w, and the contact angle is $\theta$, the contact angle $\theta$ is given by the following formula (4).

$$\theta = \sin^{-1} \frac{w}{2R} \qquad \cdots (4)$$

Similarly, the height h of the fluid can be expressed as the following formula (5).

$$h = R\left(1 - \sqrt{1 - \left(\frac{w}{2R}\right)^2}\right) \qquad \cdots (5)$$

By applying the formula (3) to the formula (4), the contact angle $\theta_1$ in the fluid flowing section A1 and the contact angle $\theta_2$ in the fluid injecting section A2 can be given by the following formula (6) and formula (7), respectively.

$$\theta_1 = \sin^{-1} \frac{b}{2R_1} \qquad \cdots (6)$$

$$\theta_2 = \sin^{-1} \frac{d}{2R_2} = \sin^{-1} \frac{d}{4R_1} \qquad \cdots (7)$$

Here, if the relationship of d=2b is satisfied, $\theta_1 = \theta_2$ is obtained from the formula (6) and the formula (7).

Further, since the bank B has lyophobicity and accordingly has a quite large contact angle with a liquid, assuming that the contact angle is no smaller than 90 degrees and no larger than 180 degrees, according to the formula (6), if d>2b, then $\theta_1 > \theta_2$ works out, and if d<2b, then $\theta_1 < \theta_2$ works out.

Note that, in order not to make the fluid flow out of the bank B when the droplet lands on the fluid injecting section A2, it is the necessary requirement that the contact angle $\theta_2$ of the fluid in the fluid injecting section A2 is arranged not to exceed the contact angle $\theta_1$ of the fluid in the fluid flowing section Al. And, after the total amount of the fluid to be injected into the fluid injecting section A2 is almost determined in consideration of the finally necessary thickness, the larger maximum fluid injection amount (the maximum fluid accumulating amount) of the fluid injecting section A2 is more advantageous to efficiently form the thin film with the fewest times of injection. Further, the line width b of the fluid flowing section Al is determined from the necessary line width of the wiring and is a basically unchangeable design value, and further, the size (the area) of the fluid injecting section A2 is also preferably smaller taking the area efficiency into consideration.

Here, in order for accumulating as much fluid as possible in the fluid injecting section A2, the capacity (the area of the bottom multiplied by the height (the depth)) of the fluid injecting section A2 needs to be larger. However, since the height of the bank B, which determines the depth of the fluid containing section, causes unevenness of the surface of the substrate, the height is preferably limited to the height substantially the same as (or slightly higher than) the thickness of the finally formed thin film.

Namely, if the contact angle $\theta_1$ and the contact angle $\theta_2$ satisfies $\theta_1 \leq \theta_2$, the maximum fluid injecting amount of the fluid injecting section A2 can be made larger.

Therefore, d≤2b is preferable, and as much fluid as possible can be injected into the fluid injecting section A2 in a short period of time.

Further, by applying the formula (3) to the formula (5), the height h1 of the fluid in the fluid flowing section A1 and the height h2 of the fluid in the fluid injecting section A2 can be given by the formula (8) and the formula (9), respectively.

$$h_1 = R_1\left(1 - \sqrt{1 - \left(\frac{b}{2R_1}\right)^2}\right) \qquad \cdots (8)$$

$$h_2 = R_2\left(1 - \sqrt{1 - \left(\frac{d}{2R_2}\right)^2}\right) = 2R_1\left(1 - \sqrt{1 - \left(\frac{d}{4R_1}\right)^2}\right) \qquad \cdots \quad (9)$$

Here, if the relationship of d=2b is satisfied, $h_2=2h_1$ is obtained from the formula (8) and the formula (9).

Namely, the final film thickness is in a positive correlation with the average height of the fluid. The average height $h_1$ of the fluid accumulated in the fluid flowing section A1 and having a semi-cylindrical shape can be obtained by dividing by the base width d the area of the semicircle calculated by integrating in a range of the base width the height of the semicircle (the cross-section) formed by cutting the semi-cylinder in the width direction. Meanwhile, the average height $h_{A2}$ of the fluid shaped as a hemisphere positioned in the fluid injecting section A2 can be obtained by dividing by the area of the base the volume of the hemisphere obtained by calculating the integration of the area of the hemicycle shown in Fig. 6E half-turned around the axis of the hemisphere. Therefore, if the height (the maximum height) $h_1$ of the semi-cylindrical fluid and the height (the maximum height) $h_2$ of the hemispheric fluid are equal ($h_1=h_2$), the average height $h_{A1}$ in the fluid flowing section A1 is higher than the average height $h_{A2}$ in the fluid injecting section A2 ($h_{A2}<h_{A1}$), and if the relationship of the height of the fluid is $h_2=2h_1$, the average height becomes no greater than double ($h_{A2}\leq 2h_{A1}$).

Therefore, if the relationship between the width d of the fluid injecting section A2 and the line width b of the fluid flowing section A1 satisfies d≤2b, then the relationship between the average heights of the fluids respectively accumulated in the fluid injecting section A2 and the fluid flowing section A1 satisfies $h_{A2}<2h_{A1}$. Accordingly, since the relationship between the thicknesses of the thin films finally obtained by drying the fluids respectively accumulated in the fluid injecting section A2 and the fluid flowing section A1 is in a positive correlation with the relationship of $h_{A2}<2h_{A1}$, the film thickness is also no greater than double, thus it becomes easy to provide the thin films to the fluid injecting section A2 and the fluid flowing section A1 so that the difference in the film thicknesses is within the allowable range.

Therefore, the diameter (the mean diameter) d of the fluid injecting section A2 is preferably set to be no greater than double the line width b of the fluid flowing section A1 (in the present embodiment, b<d0≤d≤2b (where, d0 denotes the diameter of the droplet before landing)), and particularly preferable value thereof is double (d=2b).

The first embodiment described above provides the following advantages.

By setting the relationship between the width d of the fluid injecting section A2 and the line width b of the fluid flowing section A1 to d≤2b, the contact angle $\theta_2$ of the fluid in the fluid injecting section A2 becomes larger than the contact angle θ1 of the fluid in the fluid flowing section A1, thus the maximum fluid injecting amount when injecting a fluid to the fluid injecting section A2 can be as mach as possible. Namely, the thin film pattern can efficiently be formed with the minimum number of times of injection.

(2) Since the fluid injected to the fluid injecting section A2 can be promoted to efficiently flow to the fluid flowing section A1, and the ratio of the heights of the fluids in the fluid injecting section A2 and in the fluid flowing section A1 can satisfy no greater than double, the film thicknesses can be set substantially equal within the allowable range (The film thickness in the fluid injecting section A2 and the film thickness in the fluid flowing section A1 become substantially equal.). Therefore, a finer thin film pattern can be formed.

(3) If a large amount of liquid remains in the fluid injecting section A2, the evaporation speed in the fluid injecting section A2 and the evaporation speed in the fluid flowing section A1 are different from each other sometimes resulting in degradation of the evenness of the film. According to the present embodiment of the invention, since the evaporation speeds are substantially the same, the evenness of the film in the drying process can easily be obtained. Namely, since the film thickness in the fluid injecting section A2 and the film thickness in the fluid flowing section A1 are substantially the same, the thin film pattern without substantial unevenness can be formed.

(4) Further, if additional films of other materials are stacked on the thin film pattern in succeeding processes (thin film formation by dry processes or wet processes) to form a multi-layered film having a multi-layered structure, since the film is the thin film pattern without substantial unevenness, the multi-layered film capable of preventing quality problems such as breaking of wire or short circuit from occurring can be formed, thus providing devices having stable quality.

Second Embodiment

A second embodiment of the invention will hereinafter be described. The second embodiment is different from the first embodiment described above in that the shape of the fluid injecting section A2 is changed to be an elliptical shape.

Note that the same components as the first embodiment and the components having similar functions to those in the first embodiment are provided with the same references, and the descriptions therefor will be omitted.

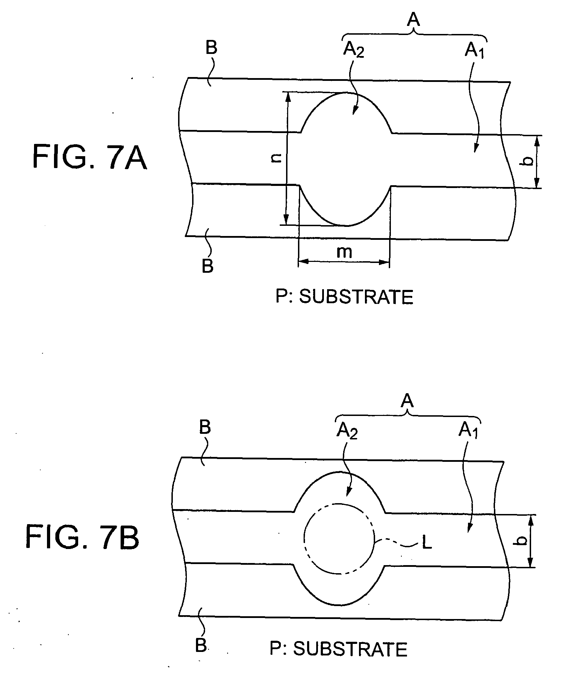

Figs. 7A and 7B are conceptual diagrams of the thin film pattern forming method as the second embodiment.

As shown in Fig. 7A, the thin film pattern is arranged to form the fluid injecting section A2 having the elliptical shape in the linear area A partitioned by the bank B when the bank B is formed on the substrate P. In this case, it is arranged that the harmonic average of the two main diameters, the minor axis m and the major axis n, of the fluid injecting section A2 is at least no wider than double the width b of the fluid flowing section A1.

As shown in Fig. 7B, it is arranged that the functional fluid L can be disposed on the linear area A partitioned by the bank B formed on the substrate P. When the dropped functional fluid L tries to spread in the area of the fluid injecting section A2, the force to be the stabilized state by the surface tension operates to make the surface of the droplet hemispheric (See Fig. 6C.).

Here, prior to the fluid injecting section A2 is filled with the functional fluid L, the functional fluid starts flowing from the fluid injecting section A2 along the longitudinal direction of the fluid flowing section A1, and is accumulated in the fluid flowing section A1. The functional fluid L accumulated in the fluid flowing section A1 becomes a substantially hog-backed shape (substantially semi-cylindrical shape) (See Fig. 6D.).

Here, assuming that the minor axis of the fluid injecting section A2 is m, the major axis thereof is n, the line width of the fluid flowing section A1 is b, and the liquid surface curvature radiuses in the center of the ellipse are $R_{2m}$, $R_{2n}$, the following formula (10) is given. Note that the formula (10) is an approximation formula.

$$R_{2m} : R_{2n} \sim m : n \qquad \cdots (10)$$

Therefore, the formula (11) can be obtained from the formula (10).

$$R_{2n} \sim \frac{n}{m} R_{2m} \qquad \cdots (11)$$

The conditions of pressure balance in the steady state can be given by the formula (12).

$$\frac{1}{R_{2n}} + \frac{1}{R_{2M}} = \frac{1}{R_1} \qquad \cdots (12)$$

Therefore, the formula (13) can be obtained from the formula (12).

$$\left(1 + \frac{m}{n}\right) R_1 = R_{2m} \qquad \cdots (13)$$

Assuming here that m equals n, it becomes similar to the case with the circle obtained in the first embodiment (See the formula (3).).

Further, since the maximum contact angle is obtained at the edge in the minor axis direction in the fluid injecting section A2, the curvature radius $R_{2m}$ in the minor axis direction can be used.

The contact angles in case of the ellipse will be explained here. The contact angle $\theta_1$ of the fluid flowing section A1 can be expressed as the formula (14) by using the formula (12) instead of the formula (3) in the first embodiment.

$$\theta_1 = \sin^{-1} \frac{b}{2R_1} \qquad \cdots (14)$$

Similarly, by using the formula (13), the contact angle θ2 in the fluid injecting section A2 can be given by the formula (15).

$$\theta_2 = \sin^{-1} \frac{m}{2R_{2m}} = \sin^{-1} \frac{m}{2\left(1 + \frac{m}{n}\right) R_1} \qquad \cdots (15)$$

Therefore, the line width b of the fluid flowing section A1 is given by the formula (16) from the formula (14) and the formula (15), and in this state, $\theta_1=\theta_2$ can be obtained.

$$b = \frac{m}{1+\frac{m}{n}} \qquad \cdots (16)$$

Therefore, the formula (17) can be obtained from the formula (16).

$$\frac{1}{b} = \frac{1}{m} + \frac{1}{n} \qquad \cdots (17)$$

Namely, similarly to the first embodiment, the pressure $P_2$ of the functional droplet L2 accumulated in the fluid injecting section A2 and the pressure $P_1$ of the functional droplet L1 flowing to the fluid flowing section A1 are balanced with each other in the steady state. The relationship between the pressures becomes P1=P2, the harmonic average of the two main diameters, the minor axis m and the major axis n, of the fluid injecting section A2 is preferably no greater than double the line width b of the fluid flowing section A1, and is further preferably double the line width b.

According to the second embodiment described above, the following advantages can be obtained.

(5) Since the relationship between the functional droplet L2 dropped on the fluid injecting section A2 and the functional droplet L1 flowing to the fluid flowing section A1 is substantially the same as the first embodiment even if the shape of the fluid injecting section A2 is changed to be an ellipse, the same kind of advantages can be obtained.

Third Embodiment

A third embodiment of the invention will hereinafter be described. The third embodiment is different from the first and the second embodiments described above in that the shape of the fluid injecting section A2 is changed to be a square shape.

Note that the same components as the first and the second embodiments and the components having similar functions to those in the first and the second embodiments are provided with the same references, and the descriptions therefor will be omitted.

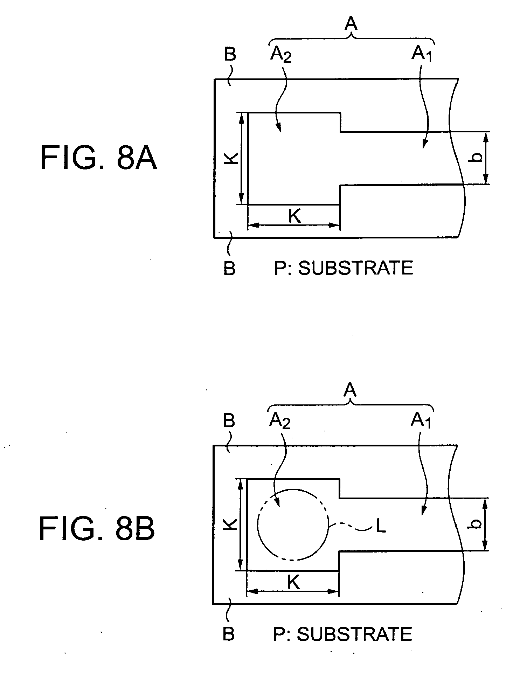

Figs. 8A and 8B are conceptual diagrams of the thin film pattern forming method as the third embodiment.

As shown in Fig. 8A, the thin film pattern is arranged to form the fluid injecting section A2 having the square shape in the linear area A partitioned by the bank B when the bank B is formed on the substrate P. Further more, it is arranged that the length K of one side of the fluid injecting section A2 is at least no greater than double the width b of the fluid flowing section A1.

As shown in Fig. 8B, it is arranged that the functional fluid L can be disposed on the linear area A partitioned by the bank B formed on the substrate P. When the dropped functional fluid L tries to spread in the area of the fluid injecting section A2, the force to be the stabilized state by the surface tension operates to make the surface of the droplet hemispheric (See Fig. 6C.).

Here, when the fluid injecting section A2 is filled with the functional fluid L, the functional fluid starts flowing from the fluid injecting section A2 along the longitudinal direction of the fluid flowing section A1, and is accumulated in the fluid flowing section A1. The functional fluid L accumulated in the fluid flowing section A1 becomes a substantially hog-backed shape (substantially semi-cylindrical shape) (See Fig. 6D.).

Namely, similarly to the first embodiment, the pressure $P_2$ of the functional droplet L2 accumulated in the fluid injecting section A2 and the pressure $P_1$ of the functional droplet L1 flowing to the fluid flowing section A1 are balanced with each other in the steady state. In this case, P1=P2 is obtained, and taking 2R1=R2 (See the formula (3).) into consideration, the length K of one side of the fluid injecting section A2 is preferably no greater than double the line width b of the fluid flowing section A1, and is particularly preferably double the line width b.

According to the third embodiment described above, the following advantages can be obtained.

(6) Since the relationship between the functional droplet L2 accumulated in the fluid injecting section A2 and the functional droplet L1 flowing to the fluid flowing section A1 is substantially the same as the first embodiment even if the shape of the fluid injecting section A2 is changed to be a square, the same kind of advantages can be obtained.

Electro-optic Device

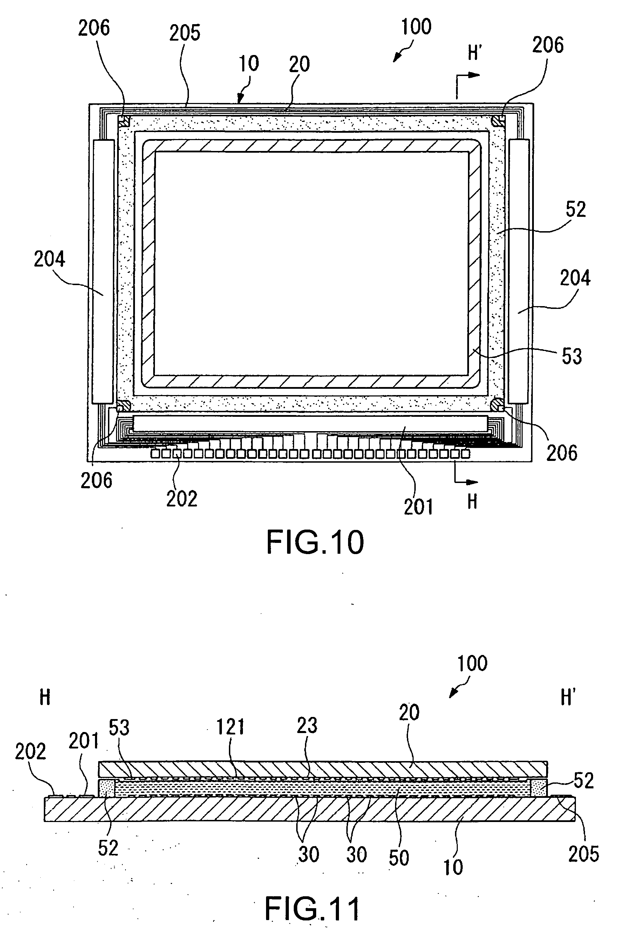

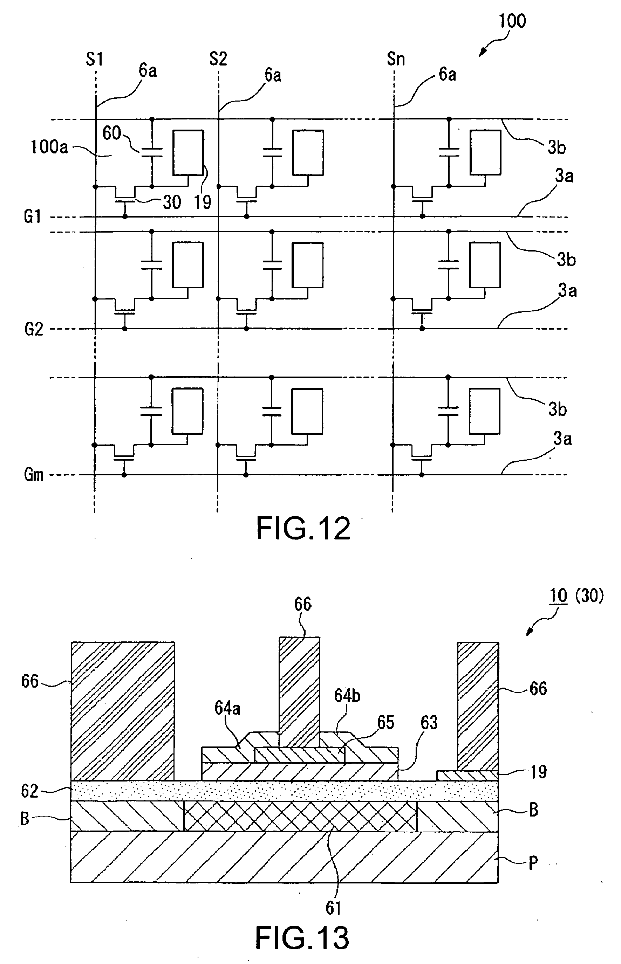

A liquid crystal display device, which is an embodiment of an electro-optic device according to the invention, will be described. Fig. 10 is a plan view showing the liquid crystal display device according to the embodiment of the invention together with various composing elements viewed from an opposing substrate, and Fig. 11 is a cross-sectional view along the H-H' line shown in Fig. 10. Fig. 12 is an equivalent circuit diagram of various elements and the wiring in the number of pixels formed as a matrix in an image display region of the liquid crystal display device, and Fig. 13 is a partial enlarged cross-sectional view of the liquid crystal display device. Note that the scale ratios of the various layers and the various members may be set differently in the drawings used in the description below in order for illustrating the various layers and the various members in visible sizes on the drawings.

In Figs. 10 and 11, the liquid crystal display device (electro-optic device) 100 according to an embodiment of the invention has a structure in which the TFT array substrate 10 and the opposing substrate 20 making a pair are adhered to each other with a seal member 52, the light curing sealant, and the liquid crystal 50 is encapsulated and held in the region partitioned with the seal member 52. The seal member 52 is formed in the surface of the substrate as a closed frame.

In the inner area of the area in which the sealing member 52 is formed, there is provided a periphery cover 53 made of a light blocking material. In the outer area of the sealing member 52, there are provided a data line drive circuit 201 and mounting terminals 202 along one side of the TFT array substrate 10, and scanning line drive circuits 204 are formed along two sides adjacent to the one side. In the remaining side of the TFT array substrate 10, there are provided a number of wiring 205 for connecting the scanning line drive circuits 204 provided on the both sides of the image display area. Further, on at least one corner of the opposing substrate 20, there is provided an inter-substrate connecting member 206 for achieving electrical conduction between the TFT array substrate 10 and the opposing substrate 20.

. Note that, instead of forming the data line drive circuit 201 and the scanning line drive circuits 204 on the TFT array substrate 10, for example, a TAB (Tape Automated Bonding) substrate equipped with a driver LSI and a group of terminals provided to the periphery of the TFT array substrate 10 can electrically and mechanically be connected to each other via an anisotropic conductive film. Note that, although in the liquid crystal display device 100, a wave plate, a deflecting plate, and so on are disposed in appropriate orientations in accordance with a nature of the used liquid crystal, namely, the operational mode such as a TN (Twisted Nematic) mode or a STN (Super Twisted Nematic) mode, or other modes such as normally white mode or normally black mode, the illustration thereof will be omitted here. Further, if the liquid crystal display device 100 is configured to be used as a color display, color filters for red (R), green (G), and blue (B), for example, are formed with their protective films in the area of the opposing substrate 20 facing the respective pixel electrodes, described below, of the TFT array substrate 10.

In the image display area of the liquid crystal display device 100 having such a structure, as shown in Fig. 12, a number of pixels 100a are configured as a matrix, and each of the pixels 100a is provided with a TFT (a switching device) 30 for pixel-switching, and the data line 6a for supplying a pixel signal S1, S2, ...,or Sn is electrically connected to the source of the TFT 30. The pixel signals S1, S2, ..., and Sn to be provided to the data lines 6a can respectively be supplied to each data line in this order, or can respectively be supplied to each group composed of a number of adjacent data lines 6a. Further, the scanning lines 3a are electrically connected to the gates of the TFTs 30, and it is configured that the scanning signals G1, G2, ..., Gm are respectively supplied to the scanning lines 3a at a predetermined timing in forms of pulses in this order.

The pixel electrodes 19 are electrically connected to the respective drains of the TFTs 30, by turning on the TFTs 30, the switching elements, for a predetermined period of time, the image signals S1, S2, ..., Sn supplied from the data lines 6a are stored in the respective pixels at a predetermined timing. According to this operation, the image signals S1, S2, ...,Sn of predetermined levels stored in the liquid crystal via the pixel electrodes 19 are held between the pixel electrodes and the opposing electrodes 121 of the opposing substrate 20 shown in Fig. 11 for a predetermined period of time. Note that, in order for preventing leakage of the pixel signals S1, S2, ..., Sn held therebetween, storage capacitors 60 are additionally provided in parallel with the liquid crystal capacitors formed between the pixel electrodes 19 and the opposing electrodes 121. For example, the voltages of the pixel electrodes 19 are held by the storage capacitors 60 for as long as three times the period the source voltages are applied for. Accordingly, the charge holding performance is improved, thus the liquid crystal display device 100 having a high contrast ratio can be realized.

Fig. 13 is a partial enlarged cross-sectional view of the liquid crystal display device 100 equipped with a bottom gate type TFT 30, and the glass substrate P composing the TFT array substrate 10 is provided with gate wiring 61 on the glass substrate P in the area surrounded by the bank B using the wiring pattern forming method according to the embodiment of the invention described above.

On the gate wiring 61, a semiconductor layer 63 composed of an amorphous silicon (a-Si) layer is stacked via a gate insulating film 62 composed of SiNx. The area of the semiconductor layer 63 opposing to the gate wiring section is defined as the channel region. On the semiconductor layer 63, bonding layers 64a and 64b formed of, for example, n+ type of a-Si layer are stacked in order for obtaining ohmic contact, and in the center section of the channel region, an insulating etch stop film 65 composed of SiNx for protecting the channel is formed on the semiconductor layer 63. Note that the gate insulating film 62, the semiconductor layer 63, and the etch stop film 65 can be patterned as shown in the drawing by coated with the resist, exposed and developed, and then photo-etched after deposited (CVD).

Further, the bonding layers 64a, 64b and the pixel electrode 19 made of ITO can also be patterned as shown in the drawing by photo-etched after similarly deposited. And, the bank 66 is provided on the pixel electrode, the gate insulating film 62, and the etch stop film 65 in an extended condition, and then the droplets of silver compounds are ejected to the areas surrounded by the bank using the droplet ejection device IJ described above to form the source line and the drain line.

Note that, although the configuration, in which the TFTs 30 are used as the switching elements for driving the liquid crystal display device 100, is described in the above embodiment, it can be applied to, for example, an organic EL (electroluminescence) display device other than the liquid crystal display device. The organic EL display device having a structure, in which a thin film including an inorganic or an organic fluorescent compound is sandwiched by a cathode and an anode, is an element that generates excitons by injecting electrons and holes to the thin film and recombining them, and emits light by utilizing emission (fluorescence or phosphorescence) of light caused by deactivation of the excitons. And, a light-emitting full-color EL device can be manufactured by respectively patterning on the substrate provided with TFTs 30 described above using ink of the light emitting layer forming materials, namely materials respectively presenting red, green, and blue selected from the fluorescent materials used for organic EL display elements, and ink of a material for forming a hole injection/electron transport layer. The range of the device (electro-optic device) of the invention also includes such an organic EL device.

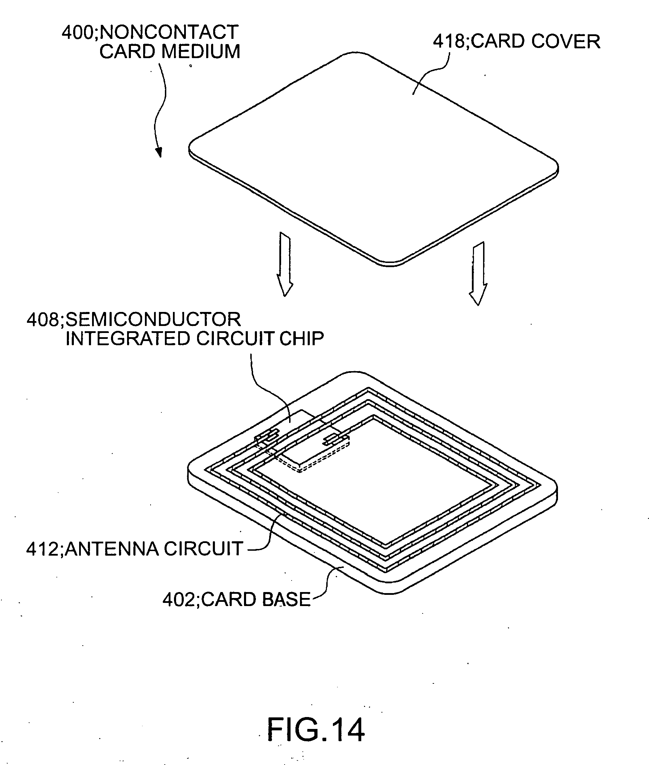

As another embodiment of the invention, an embodiment of the noncontact card medium will be explained. As shown in Fig. 14, the noncontact card medium (an electronic instrument) 400 according to the present embodiment includes a semiconductor integrated circuit chip 408 and an antenna circuit 412 accommodated in a case composed of a card base 402 and a card cover 418, and executes at least one of a power supply operation and a data communicating operation by at least one of electromagnetic wave coupling and electrostatic coupling with an external transceiver. In the present embodiment, the antenna circuit 412 is formed using the wiring pattern forming method according to the embodiment described above.

Note that, as the device (electro-optic device) according to the invention, in addition to the above devices, a PDP (Plasma Display Panel), and a surface-conduction electron-emitter display, which utilizes a phenomenon of generating electron emission by making current flow in parallel with the surface of a thin film having the small area provided on the substrate, can be adopted.

Electronic Instrument

Specific examples of an electronic instrument according to the invention will hereinafter be described.

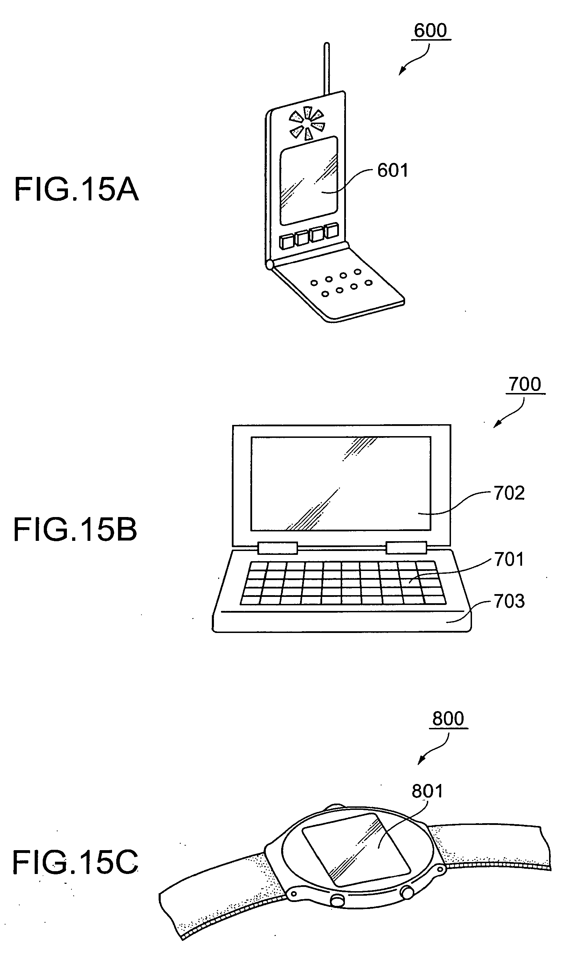

Fig. 15A is a perspective view showing an example of a cellular phone. In Fig. 15A, the reference numeral 600 denotes a main body of the cellular phone, and the reference numeral 601 denotes a liquid crystal display section equipped with the liquid crystal display device according to the above embodiment.

Fig. 15B is a perspective view showing an example of a portable data processing device such as a word processor or a personal computer. In Fig. 15B, the reference numeral 700 denotes an information processing device, the reference numeral 701 denotes an input section such as a keyboard, the reference numeral 703 denotes an information processing main body, and the reference numeral 702 denotes a liquid crystal display section equipped with the liquid crystal display device according to the above embodiment.

Fig. 15C is a perspective view showing an example of a wrist watch type of electronic instrument. In Fig. 15C, the reference numeral 800 denotes a main body of the watch, and the reference numeral 801 denotes a liquid crystal display section equipped with the liquid crystal display device according to the above embodiment.

The electronic instruments shown in Figs. 15A through 15C are equipped with the liquid crystal display device according to the above embodiment, and have wiring patterns with fine lines in good conditions.

Note that, although the electronic instruments according to the present embodiment are described as being equipped with the liquid crystal display device, they can be electronic instruments equipped with another electro-optic device such as an organic electroluminescence display device or a plasma display device.

Note that the invention is not limited to the embodiments described above but includes modifications and improvements in a range where the advantages of the invention can be achieved. Modified examples will be described below.

Modified Example 1

Although in the first through third embodiments, the descriptions read that the bank is formed, and then the bank is provided with lyophobicity, the invention is not so limited. For example, the bank can be omitted. For example, a surface treatment is executed on the substrate to provide lyophilicity to the areas on which the wiring pattern is formed, and to provide lyophobicity to the other areas, and then ink containing conductive fine particles or organo-silver compounds can be disposed on the areas provided with lyophilicity.

By thus processed, a desired wiring pattern can be formed.

Modified Example 2

In the configurations of the first through third embodiments, although the thin film patterns are the conductive films, the invention is not so limited. For example, it can be applied to a color filter used for colorizing display images in liquid crystal display devices. The color filter can be formed by disposing the ink (fluid materials) of R (red), G (green), and B (blue) as droplets on the substrate in a predetermined pattern. Or, The color filter can be formed by providing a bank corresponding to the predetermined pattern, and then disposing the ink after providing lyophobicity to the bank.

By thus processed, a liquid crystal display equipped with a high-performance color filter can be manufactured.

Modified Example 3

As described regarding the first through third embodiments, although the bank is provided in the periphery of the fluid injecting section A2, the invention is not so limited. For example, the fluid injecting section A2 and the fluid flowing section A1 can be formed without providing the bank.

By thus processed, since the relationship between the contact angle $\theta_2$ of the fluid dropped on the fluid injecting section A2 and the contact angle $\theta_1$ of the fluid dropped on the fluid flowing section A1 is substantially the same as the first embodiment described above even if the bank is omitted, the same kind of advantages as those of the first through third embodiments can be obtained.

Modified Example 4

As described regarding the first through third embodiments, although the fluid injecting section is supplied with as much fluid as possible (nearly the maximum fluid accumulating amount), the invention is not so limited. For example, the amount of fluid supplied to the fluid injecting section A2 is not necessarily near to the maximum fluid accumulating amount.

By thus processed, since the fluid dropped to the fluid injecting section A2 is slowly accumulated in the area surrounded by the bank B, it can hardly flow out of the bank B.

Modified Example 5

As described regarding the first through third embodiments, the shape of the fluid injecting section A2 is not limited to a circular shape or an elliptical shape. For example, a substantially isotropic shape is not limited to a circular shape, but can be a regular polygon such as a square shape, an equilateral pentagon, an equilateral hexagon, an equilateral octagon, or an equilateral dodecagon, or elliptical shape having the minor axis and the major axis substantially equal to each other (the shape which can be regarded as a substantial circle). Further, the anisotropic shape is not limited to a elliptical shape, but can be an oblong shape or a rhombic shape. In essence, if the width of the fluid injecting section A2 is no greater than double the line width of the fluid flowing section A1, the shape of the fluid injecting section A2 can be called as a substantial isotropic shape, and if, on the contrary, the mean diameter of the fluid injecting section A2 is no greater than double the line width of the fluid flowing section A1, then the shape of the fluid injecting section A2 can be called as an anisotropic shape.

By thus processed, since the relationship between the contact angle $\theta_2$ of the fluid dropped on the fluid injecting section A2 and the contact angle $\theta_1$ of the fluid dropped on the fluid flowing section A1 is substantially the same as the first embodiment described above, the same kind of advantages as those of the first through third embodiments can be obtained.

Further, technical concepts which can be understood from the embodiments or the modified examples described above are as follows.

Technical Concept 1

A thin film pattern substrate provided with a thin film pattern in an area provided as a recess to the substrate, wherein the recess area includes a fluid injecting section to which a functional fluid is injected, the functional fluid being dried to form the thin film pattern, and a fluid flowing section having a linear shape and connected to the fluid injecting section so that the functional fluid injected to the fluid injecting section can flow into the fluid flowing section, and wherein a mean diameter of the fluid injecting section is set to be no greater than double the line width of the fluid flowing section.

According to this configuration, since the width d of the fluid injecting section A2 is set to be no greater than double the line width b of the fluid flowing section A1, the contact angle $\theta_2$ of the fluid dropped to the fluid injecting section A2 and the contact angle $\theta_1$ of the fluid dropped to the fluid flowing section A1 satisfies the relationship similar to the first embodiment, thus the same kind of advantages as the first through third embodiments can be obtained.

Technical Concept 2

A thin film pattern substrate provided with a thin film pattern in an area provided as a recess to the substrate, wherein the recess area includes a fluid injecting section to which a functional fluid is injected, the functional fluid being dried to form the thin film pattern, and a fluid flowing section having a linear shape and connected to the fluid injecting section so that the functional fluid injected to the fluid injecting section can flow into the fluid flowing section, and wherein the fluid injecting section has a substantially isotropic shape having substantially the same diameters in different directions, and the width of the fluid injecting section is set to be no greater than double the line width of the fluid flowing section.

According to this configuration, since the diameters of the fluid injecting section in different directions are substantially the same and the width d of the fluid injecting section A2 is set to be no greater than double the line width b of the fluid flowing section A1, the contact angle $\theta_2$ of the fluid dropped to the fluid injecting section A2 and the contact angle $\theta_1$ of the fluid dropped to the fluid flowing section A1 satisfies the relationship similar to the first embodiment, thus the same kind of advantages as the first through third embodiments can be obtained.

Technical Concept 3

A thin film pattern substrate provided with a thin film pattern in an area provided as a recess to the substrate, wherein the recess area includes a fluid injecting section to which a functional fluid is injected, the functional fluid being dried to form the thin film pattern, and a fluid flowing section having a linear shape and connected to the fluid injecting section so that the functional fluid injected to the fluid injecting section can flow into the fluid flowing section, and wherein the fluid injecting section has a anisotropic shape having different diameters in different directions, and a mean diameter of the fluid injecting section is set to be no greater than double the line width of the fluid flowing section.

According to this configuration, although the fluid injecting section has anisotropic shape in different directions, since the width d of the fluid injecting section A2 is set to be no greater than double the line width b of the fluid flowing section A1, the contact angle $\theta_2$ of the fluid dropped to the fluid injecting section A2 and the contact angle $\theta_1$ of the fluid dropped to the fluid flowing section A1 satisfies the relationship similar to the first embodiment, thus the same kind of advantages as the first through third embodiments can be obtained.

**Claims**

1. A thin film pattern substrate, comprising:

   an area provided to the substrate to form a recess and including a wider section and a linear section connected to the wider section, wherein the wider section having a width greater than the width of the linear section; and
   a thin film pattern provided on the area, wherein
   a mean diameter of the wider section is set to be no greater than double the width of the linear section.

2. The thin film pattern substrate according to Claim 1, wherein
   the wider section has a substantially isotropic shape having substantially the same diameters in different directions, and
   the width of the wider section is set to be no greater than double the width of the linear section.

3. The thin film pattern substrate according to Claim 1, wherein
   the wider section has an anisotropic shape having different diameters in different directions, and
   a mean diameter of the wider section is set to be no greater than double the width of the linear section.

4. The thin film pattern substrate according to Claim 2, wherein
   the substantially isotropic shape of the wider section is a substantially circular shape.

5. The thin film pattern substrate according to Claim 3, wherein
   the anisotropic shape of the wider section is an elliptic shape, and
   a harmonic average of a minor axis and a major axis of the wider section is set to be no greater than double the width of the linear section.

6. The thin film pattern substrate according to Claim 1, wherein
   the wider section is a fluid injecting section to which a functional fluid is injected, the functional fluid being dried to form the thin film pattern, and
   the linear section is a fluid flowing section having a linear shape and connected to the fluid injecting section so that the functional fluid injected to the fluid injecting section can flow into the fluid flowing section.

7. The thin film pattern substrate according to Claim 1, further comprising:

   a bank section, wherein the area provided to form the recess is formed inside the bank section.

8. The thin film pattern substrate according to Claim 7, wherein
   the area provided to form the recess is a lyophilic section.

9. The thin film pattern substrate according to Claim 1, wherein
   the functional fluid is injected to the wider section using an inkjet process.

10. The thin film pattern substrate according to Claim 7, wherein
    the area provided to form the recess is a conductive pattern.

11. A method of manufacturing a device on a surface of a substrate, comprising:

    forming a wider section on the substrate;

forming a linear section on the substrate so that the linear section is connected to the wider section to allow a functional fluid to flow;
injecting the functional fluid to the wider section;
allowing the functional fluid to flow from the wider section into the linear section; and
drying the functional fluid flowing into the linear section to form a thin film pattern, wherein
a mean diameter of the wider section is set to be no greater than double the width of the linear section.

**12.** An electro-optic device comprising a device including the thin film pattern substrate according to Claim 1.

**13.** An electronic instrument comprising the electro-optic device according to Claim 12.

FIG. 1

FIG. 2

BANK FORMING STEP — S1

↓

LYOPHILICITY PROVIDING STEP — S2

↓

LYOPHOBICITY PROVIDING STEP — S3

↓

MATERIAL DISPOSING STEP — S4

↓

PRELIMINARY DRYING STEP — S5

↓

CALCINING STEP — S6

⋮

# FIG. 3

FIG. 4A

FIG. 4B

FIG. 4C

FIG. 5A

FIG. 5B

FIG. 5C

FIG. 6A

FIG. 6B

FIG. 6C

FIG. 6D

FIG. 6E

FIG. 7A

B

A

A₂          A₁

n

b

m

P: SUBSTRATE

FIG. 7B

B

A

A₂          A₁

L

b

B

P: SUBSTRATE

FIG. 8A

FIG. 8B

P: SUBSTRATE

**FIG. 9**

FIG.10

FIG.11

**FIG.12**

**FIG.13**

400;NONCONTACT
CARD MEDIUM

418;CARD COVER

408;SEMICONDUCTOR
INTEGRATED CIRCUIT CHIP

412;ANTENNA CIRCUIT

402;CARD BASE

FIG.14

600

FIG.15A

601

700

FIG.15B

702

701

703

800

801

FIG.15C